# EUROPÄISCHE PATENTSCHRIFT

(11) **EP 0 603 555 B1**
(45) Veröffentlichungstag und Bekanntmachung des Hinweises auf die Patenterteilung: **11.09.1996**
(21) Anmeldenummer: 93118733.0
(22) Anmeldetag: 22.11.1993
(51) Int. Cl.: H01J 37/04, H01J 37/26

(54) **Verfahren zur Beleuchtung mit einem fokussierten Elektronenstrahl und zugehöriges elektronen-optisches Beleuchtungssystem**
Method of illumination by focussed electron beam and electron optical illumination system
Procédé d'illumination par un faisceau d'électron focalisé et système d'optique électronique d'illumination pour la mise en oeuvre dudit procédé

(30) Priorität: 22.12.1992 DE 4243489
(43) Veröffentlichungstag der Anmeldung: 29.06.1994
(73) Patentinhaber: Carl Zeiss, D-89520 Heidenheim (Brenz) (DE)
(72) Erfinder: Benner, Gerd, Dr., D-73434 Aalen (DE)

(56) Entgegenhaltungen:
- EP-A- 0 352 552
- EP-A- 0 367 496
- US-A- 4 547 669

## Beschreibung

Die vorliegende Erfindung betrifft ein Verfahren zur Beleuchtung eines Objektes mit einem fokussierten Elektronenstrahl und ein zugehöriges elektronen-optisches Beleuchtungssystem.

Elektronensonden, also fokussierte Elektronenstrahlen mit einem sehr kleinen Fokusdurchmesser, werden in der Elektronenmikroskopie sowohl zur Erzeugung rastermikroskopischer Bilder von Oberflächen als auch zur Erzeugung rastermikroskopischer Bilder von durchstrahlbaren Objekten verwendet. Desweiteren sind Anwendungen in der Materialanalyse z.B. mittels der durch den Elektronenstrahl im Objekt erzeugten Röntgenstrahlung, der Energieverlustspektroskopie und zur dreidimensionalen Strukturanalyse durch konvergente Beugung bekannt.

Der Fokusdurchmesser des Elektronenstrahls auf dem Objekt wird im allgemeinen durch die verkleinerte Abbildung des Cross-overs der Elektronenquelle mit Hilfe von mehreren Kondensorlinsen und einer Objektivlinse definiert. Die Apertur des Elektronenstrahls wird durch eine Kondensorblende eingestellt. Um für einen gewünschten Sondendurchmesser einen maximalen Elektronenstrom zu erreichen, ist die Apertur so zu wählen, daß keine wesentliche Verbreiterung der Elektronensonde durch den Öffnungsfehler des Beleuchtungssystems auftritt. Der Öffnungsfehler insbesondere der Objektivlinse eines Rasterelektronenmikroskops erfordert somit eine Anpassung der Sondenapertur an den gewählten Fokusdurchmesser.

Die konvergente Beugung ist ein Mikrobeugunsverfahren, bei dem der Fokus des Elektronenstrahls auf dem Objekt stationär ist. Zur Anpassung des Konvergenzwinkels an den Braggwinkel des Kristalls und zur Einstellung unterschiedlicher Beugungsdiagramme (z.B. Kossel-Diagramm oder Kossel-Mollenstedt-Diagramm) ist eine variable Einstellung der Apertur, also des Konvergenzwinkels, erforderlich.

Aus dem US-Patent Nr. US-A-4,626,689 ist ein elektronenmikroskopisches Beleuchtungssystem bekannt, bei dem der Crossover der Elektronenquelle über einen dreistufigen Kondensor und eine weitere Elektronenlinse auf das Objekt fokussiert wird. Die dritte Kondensorstufe ist nur schwach erregt und erzeugt lediglich ein imaginäres Bild. Die Erregungen der vier Linsen sind so gewählt, daß sich bei konstantem Fokusdurchmesser mit einer einzigen festen Kondensorblende unterschiedliche Konvergenzwinkel einstellen lassen. Es hat sich jedoch gezeigt, daß die gleichzeitige Einstellung eines konstanten Fokusdurchmessers und einer variablen Apertur den Variationsbereich der Apertur stark einschränkt. Je nach Wahl des Blendendurchmessers erfordert bereits eine Variation der Apertur um einen Faktor 1,5 bis 2 einen mechanischen Wechsel der Kondensorblende, was eine Nachzentrierung der eingewechselten Blende erfordert.

Die Oberbegriffe der Ansprüche 1 und 5 gehen von dem EP-A-0 352 552 (Us-Patent Nr. 5,013,913) der Anmelderin aus, aus dem ebenfalls ein rasterelektronenmikroskopisches Beleuchtungssystem mit einem dreistufigen Kondensor und einem nachgeschalteten Objektiv bekannt ist. Hier erzeugt die dritte Kondensorlinse ein reelles Bild des Crossovers in der Eingangsbildebene des Objektivs. Der Fokusdurchmesser des Elektronenstrahls ist durch Variation der Erregungen der beiden ersten Kondensorlinsen, die als Zoomsystem wirken, variierbar. Die Apertur des Beleuchtungsstrahlenbündels ist durch eine Kondensorblende gegeben, die entweder vor oder hinter der Eingangsbildebene der Objektivlinse angeordnet sein kann. Desweiteren sind mehrere Ausführungsbeispiele für die Einstellung Köhlerscher Beleuchtungsbedingungen bei einem Elektronenmikroskop beschrieben. Zur Einstellung eines von der Beleuchtungsapertur unabhängigen Leuchtfeldes ist in der Nähe der Hauptebene der dritten Kondensorstufe eine Mehrfachblende angeordnet. Die mit Hilfe eines oder mehrerer Strahlablenker ausgewählte Blendenöffnung der Mehrfachblende bestimmt hier jedoch die Größe des Leuchtfeldes auf dem Objekt. Ob, und in welcher Weise eine solche Mehrfachblende auch bei einem Beleuchtungssystem, bei dem der Elektronenstrahl auf das Objekt fokussiert wird, und die Variation des Fokusdurchmessers über die Erregungen der ersten beiden Kondensorlinsen erfolgt, einsetzbar ist, ist dieser Schrift jedoch nicht entnehmbar.

Aus der EP-A-0 179 294 ist ein ionen-optisches Beleuchtungssystem bekannt, bei dem der Crossover der Ionenquelle über ein zweistufiges Abbildungssystem auf die Objektoberfläche fokussiert ist. Zwischen den beiden Abbildungsstufen ist eine Mehrfachblende angeordnet. Über ebenfalls zwischengeschaltete Strahlablenksysteme kann zur Variation der Beleuchtungsapertur eine einzelne öffnung der Mehrfachblende ausgewählt werden. Eine voneinander unabhängige Variation des Fokusdurchmessers und der Beleuchtungsapertur ist bei diesem System jedoch nicht möglich, da sich bei einer Änderung der Linsenerregungen gleichzeitig auch der Abstand zwischen der Mehrfachblende und der Zwischenbildebene und damit die Beleuchtungsapertur verändert.

Aus der EP-A-0 367 496 bzw. der US-A-5,051,556 ist eine Elektronenstrahllithographie-Einrichtung bekannt, bei der der Elektronenstrahl über ein fünfstufiges Verkleinerungssystem auf den Wafer fokussiert wird. In der Ebene der zweiten Abbildungsstufe ist eine Maske mit einer Vielzahl von Teilfeldern angeordnet. Die Auswahl des gewünschten Maskenfeldes erfolgt dabei durch Auslenkung und anschließende Rücklenkung des Elektronenstrahls aus bzw. in die Richtung der optischen Achse. Bei solchen Lithographie-Einrichtungen dient die Maske jedoch nicht zur Einstellung einer bestimmten Beleuchtungsapertur, sondern zur Aufprägung eines bestimmten Musters, das nachfolgend verkleinert auf das Objekt abgebildet wird.

Die vorliegende Erfindung soll ein möglichst einfaches Beleuchtungsverfahren und eine zugehörige Beleuchtungseinrichtung für die Beleuchtung eines Objektes mit einem fokussierten Elektronenstrahl liefern, bei dem sowohl die Apertur als auch der Fokusdurchmesser des fokussierten Elektronenstrahls unabhängig voneinander einstellbar sind.

Dieses Ziel wird erfindungsgemäß durch ein Beleuchtungsverfahren mit den Merkmalen des Anspruchs 1 und durch ein elektronen-optisches Beleuchtungssystem nach Anspruch 5 erreicht.

Bei dem erfindungsgemäßen Beleuchtungsverfahren wird der Crossover der Elektronenquelle über mindestens vier Abbildungsstufen stark verkleinert auf das Objekt abgebildet. Zwei der mindestens vier Abbildungsstufen werden als ein Zoomsystem betrieben. Durch die Wahl der Erregungen dieser beiden Abbildungsstufen ist der Abbildungsmaßstab des Cross-overs in den nachfolgenden Zwischenbildebenen und auf dem Objekt variierbar. Im weiteren Verlauf wird der Elektronenstrahl durch eine in der Nähe einer Hauptebene der dritten Abbildungsstufe angeordneten Mehrfachblende, die in einer Ebene mehrere, unter anderem auch außeraxiale Öffnungen aufweist, zur Einstellung der Beleuchtungsapertur beschnitten. Die Öffnungen der Mehrfachblende haben unterschiedliche Größe. Dadurch läßt sich durch Auswahl der gewünschten Blende die Apertur des Elektronenstrahls unabhängig von dem durch das Zoomsystem variierbaren Fokusdurchmesser einstellen.

Die Blendenauswahl erfolgt dabei ohne eine mechanische Verschiebung der Mehrfachblende. Stattdessen erfolgt die Blendenauswahl auf elektronen-optischem Wege mit Hilfe geeigneter Strahlablenksysteme.

Im einfachsten Fall erfolgt die Auswahl der Blendenöffnung durch ein einziges Umlenkelement, dessen Kippebene in einer Zwischenbildebene des Crossovers liegt. Es ist mit diesem einzigen Umlenkelement möglich, den durch eine außeraxiale Öffnung transmittierten Elektronenstrahl in Richtung der optischen Achse zurückzulenken.

Ein erfindungsgemäßes elektronen-optisches Beleuchtungssystem besteht vorzugsweise aus einer Strahlungsquelle, einem mindestens dreistufigen Kondensor und einem dem Kondensor nachgeschalteten Objektiv. Zwischen der ersten Kondensorlinse und dem Objektiv befinden sich mindestens zwei reelle Zwischenbildebenen des Crossovers. Die beiden ersten, dem Cross-over der Strahlungsquelle zugewandten, Kondensorlinsen bilden ein Zoomsystem, durch das ein Zwischenbild des Crossovers mit variablem Abbildungsmaßstab in einer festen ersten Zwischenbildebene erzeugt ist. Diese erste Zwischenbildebene ist zugleich die Eingangsbildebene der dritten Kondensorlinse. Die dritte Kondensorlinse erzeugt ein zweites reelles Zwischenbild des Crossovers in der Eingangsbildebene des Objektivs und das Objektiv bildet dieses zweite Zwischenbild des Crossovers reell auf das Objekt ab. Insgesamt entsteht dadurch ein in drei nacheinanderfolgenden Stufen verkleinertes Bild des Cross-overs auf dem Objekt.

Zwischen der dritten Kondensorstufe und der Eingangsbildebene des Objektivs, vorzugsweise in der Hauptebene der dritten Kondensorstufe, ist eine Mehrfachblende mit mehreren, zum Teil außeraxialen Öffnungen mit unterschiedlichen Größen angeordnet. Diese Öffnungen der Mehrfachblende stellen Aperturblenden dar, wobei die Apertur des Elektronenstrahls durch Auswahl des durch eine einzige Öffnung transmittierten Elektronenstrahls einstellbar ist. Da die Mehrfachblende senkrecht zur gemeinsamen optischen Achse der vier Abbildungsstufen und zwischen der dritten Kondensorstufe und der Eingangsbildebene des Objektivs angeordnet ist, werden die durch die Blendenöffnungen transmittierten Elektronenstrahlen unabhängig vom Abstand der betreffenden Öffnung von der optischen Achse durch die Wirkung der dritten Kondensorlinse auf einen kleinen gemeinsamen Bereich in der Eingangsbildebene des Objektivs fokussiert. Für die Rücklenkung der außeraxialen Elektronenstrahlen in die Richtung der optischen Achse ist daher lediglich ein einziges Ablenkelement, dessen Kippebene in der Eingangsbildebene des Objektivs liegt, vorgesehen.

Für eine Abrasterung des Objektes ist die Ablenkeinheit Teil eines Doppelablenksystems, dessen gemeinsamer Kippunkt in der Brennebene des Objektivs liegt.

Da für außeraxial liegende Blendenöffnungen der Mehrfachblende die letzte Kondensorlinse zur optischen Achse geneigt durchstrahlt wird, sollte zwischen der Eingangsbildebene und der Hauptebene des Objektivs ein Stigmator vorgesehen sein, wobei der Stigmatorstrom in Abhängigkeit der vom ersten Ablenkelement bewirkten Strahlablenkung gewählt ist.

Für eine Begrenzung des auf der Mehrfachblende ausgeleuchteten Bereiches ist vor der Eingangsbildebene der dritten Kondensorstufe, vorzugsweise in der Hauptebene der zweiten Kondensorstufe, eine mechanisch justierbare Strahlbegrenzungsblende vorgesehen.

In einem ersten Ausführungsbeispiel ist der Durchmesser der Strahlbegrenzungsblende so groß gewählt, daß sämtliche Öffnungen der Mehrfachblende gleichzeitig ausgeleuchtet sind. Zusätzlich ist in der vorderen Brennebene des Objektivs eine Objektivvorfeldblende vorgesehen, deren Öffnungsdurchmesser so gewählt ist, daß nur das durch eine einzige Öffnung der Mehrfachblende transmittierte Elektronenstrahlenbündel das Objektiv erreicht. Die durch die anderen Öffnungen der Mehrfachblende transmittierten Elektronenstrahlenbündel sind dagegen auf nichtdurchlässige Bereiche der Objektivvorfeldblende gelenkt. Sie tragen daher zur Beleuchtung des Objektes nicht bei. Dieses Ausführungsbeispiel hat den Vorteil, daß für die Auswahl der Blendenöffnung lediglich ein einziges Ablenkelement erforderlich ist. Für die Apertureinstellung und die Abrasterung des Objektes sind daher insgesamt lediglich zwei Ablenkelemente, die Teile eines Doppelablenksystems sind, erforderlich. Die Elektronenstromdichte ist auf der Mehrfachblende konstant, so daß auch bei Auswahl einer außeraxialen Blende der maximale Elektronenstrom im Objekt zur Verfügung steht.

Ein weiterer Vorteil dieses Ausführungsbeispiels ist, daß die Strahlbegrenzungsblende hier einen sehr großen Durchmesser hat. Durch Entfernen der Mehrfachblende kann daher auch die bei der Transmissions-Elektronenmikroskopie übliche großflächige Objektausleuchtung realisiert werden. Die Objektivvorfeldblende wirkt sich auch nicht störend beim Rasterbetrieb aus, da die gemeinsame Kippebene des Doppelablenksystems, das die Ablenkbewegung bewirkt, mit der Ebene der Objektivvorfeldblende zusammenfällt.

Bei Rasterelektronenmikroskopen, bei denen die am Objekt reflektierten oder gestreuten Elektronen detektiert werden, ist jedoch das Zwischenschalten einer Objektivvorfeldblende in der Regel nicht möglich. Bei einem für solche Anwendungen geeigneten Ausführungsbeispiel ist eine Strahlbegrenzungsblende innerhalb des Zoomsystems mit einem kleinen Öffnungsdurchmesser vorgesehen. Der Öffnungsdurchmesser der Strahlbegrenzungsblende ist derart auf die Öffnungsdurchmesser der Mehrfachblende abgestimmt, daß stets nur eine einzige Öffnung voll ausgeleuchtet ist. Bei diesem Ausführungsbeispiel ist ein zusätzliches Ablenksystem zwischen der zweiten und der dritten Kondensorstufe erforderlich, dessen Kippebene in der Eingangsbildebene der dritten Kondensorstufe liegt.

Bei beiden Ausführungsbeispielen sind sämtliche Linsen als Magnetlinsen ausgebildet. Die Erregungsströme der dritten Kondensorlinse und der Objektivlinse sind unabhängig vom gewählten Fokusdurchmesser des Elektronenstrahls auf dem Objekt und unabhängig von der gewählten Beleuchtungsapertur auf einen festen Wert eingestellt. Dadurch ist sichergestellt, daß die Eingangs- und Ausgangsbildebenen der dritten Kondensorstufe und der Objektivlinse stets mit den Kippebenen der Ablenksysteme zusammenfallen.

Die Öffnungsdurchmesser der einzelnen Öffnungen in der Mehrfachblende sollten zueinander so abgestuft sein, daß der Abstufungsfaktor, das Verhältnis der Öffnungsdurchmesser einer Blende zur nächst größeren oder nächst kleineren Blende, kleiner als zwei, vorzugsweise 1,25, ist. Die einzelnen Öffnungsdurchmesser sollten dabei alle kleiner als 100 µm sein.

Damit das Beleuchtungssystem sowohl eine möglichst große Flexibilität als auch einen möglichst großen Bedienkomfort gewährleistet, sollte die elektronische Steuereinheit für die Ablenksysteme sowohl eine manuelle Aperturwahl als auch eine automatische, an den Fokusdurchmesser des Elektronenstrahls best angepaßte Apertur gestatten.

Im folgenden werden Einzelheiten der Erfindung anhand der in den Zeichnungen dargestellten Ausführungsbeispiele näher erläutert. Im einzelnen zeigen:
- Figur 1: Den schematischen Strahlengang eines ersten, insbesondere für Transmissions-Elektronenmikroskope geeigneten Ausführungsbeispiels der Erfindung;
- Figur 2: den schematischen Strahlengang im unteren Teil des Ausführungsbeispiels nach Figur 1 bei Verwendung einer außeraxialen Blendenöffnung;
- Figur 3: den schematischen Strahlengang eines zweiten, insbesondere für Oberflächenraster-Elektronenmikroskope geeigneten Ausführungsbeispiels der Erfindung und
- Figur 4: ein Blockschaltbild der Ansteuerelektronik für die Ausführungsbeispiele nach den Figuren 1-3.

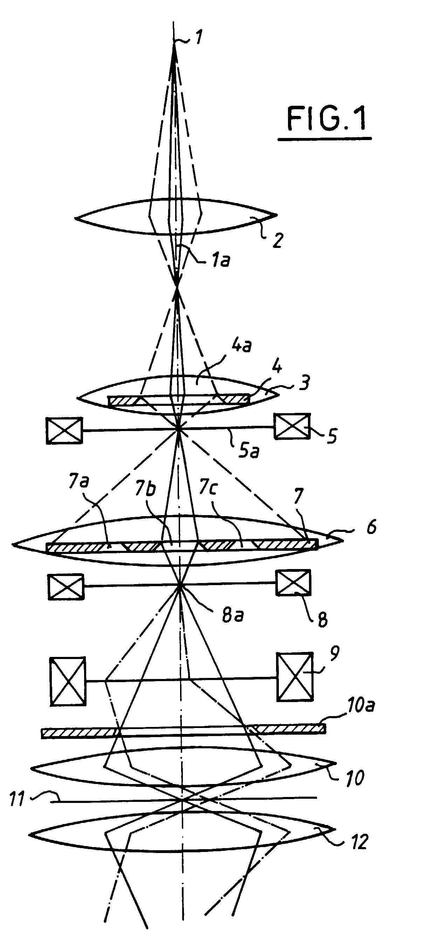

Das Elektronen-optische Beleuchtungssystem in der Figur 1 hat eine Elektronenquelle, deren Crossover mit (1) bezeichnet ist. Mit Crossover ist üblicherweise der kleinste Strahlquerschitt des Strahlerzeugungssystems bezeichnet. Dieser Cross-over (1) ist durch ein aus zwei Magnetlinsen (2, 3) bestehendes Kondensor-Zoomsystem in eine feste Ebene (5a) abgebildet. Durch gleichzeitige Änderung der Erregungen der Linsen (2) und (3) läßt sich der Abbildungsmaßstab, mit dem der Cross-over (1) in die Zwischenbildebene (5a) verkleinert abgebildet ist, variieren. Die Lage der Zwischenbildebene (5a) bleibt dabei jedoch fest.

In Strahlrichtung gesehen hinter der Zwischenbildebene (5a) ist eine dritte Kondensorlinse (6) angeordnet. Diese dritte Kondensorlinse (6) ist so erregt, daß ihre Eingangsbildebene ebenfalls mit der Zwischenbildebene (5a) zusammenfällt. Die dritte Kondensorlinse (6) bildet das in der ersten Zwischenbildebene (5a) liegende Crossover-Bild noch einmal verkleinert in eine Ebene (8a) ab, die zugleich die Eingangsbildebene des Objektivs (10) ist. Dadurch entsteht in der Objektebene (11) ein stark verkleinertes Bild des Cross-overs (1).

In der Figur 1 ist darüberhinaus noch das bei transmissions-elektronenmikroskopiSchen Untersuchungen erforderliche Objektiv (12) des Abbildungsstrahlenganges dargestellt. Die Objektive (10, 12) können auch als Objektiv-Einfeldlinse nach Ricke und Ruska ausgebildet sein.

In der Haupteben der dritten Kondensorstufe (6) ist eine Mehrfachblende (7) angeordnet, die eine axiale und sechs außeraxiale runde Öffnungen mit unterschiedlichen Öffnungsdurchmessern aufweist. Von diesen insgesamt sieben Öffnungen sind in der Figur 1 lediglich die axiale Öffnung (7b) und zwei außeraxiale Öffnungen (7a, 7c) dargestellt. Die axiale Öffnung (7b) ist dabei symmetrisch zur optischen Achse (1a) der vier Magnetlinsen (2, 3, 6, 10) des Beleuchtungssystems angeordnet. Die zusätzlich zur zentralen Öffnung vorgesehenen sechs Blendenöffnungen sind auf einem Durchmesser von 300 µm angeordnet. Der kleinste Öffnungsdurchmesser beträgt 16 µm und der Durchmesser der Blendenöffnungen erhöht sich jeweils zu der nächst größeren um den Faktor 1,25. Die größte Blendenöffnung weist damit einen Öffnungsdurchmesser von 63 µm auf. Für einen Abstand zwischen der Mehrfachblende (7) und der Objektiv-Eingangsbildebene (8a) von 30 mm und einer Verkleinerung durch das Objektiv (10) auf 1/18 ergeben sich somit für den Elektronenstrahl in der Objektebene (11) diskret abgestufte Aperturwerte zwischen 5 und 20 mrad.

Zwischen der dritten Kondensorlinse (6) und dem Objektiv (10) ist ein Doppelablenksystem (8, 9) so angeordnet, daß die Ablenkebene des ersten Ablenkelementes (8) in der Eingangsbildebene (8a) des Objektivs liegt. Eine Erregung des ersten Ablenkelementes bewirkt eine reine Kippung des Elektronenstrahls relativ zur Objektivachse (1a). Der gemeinsame Kippunkt des gesamten Doppelablenksystems (8, 9) liegt gleichzeitig in der kondensorseitigen vorderen Brennebene (10a) des Objektivs (10). Mit Hilfe des Doppelablenksystems (8, 9) läßt sich der fokussierte Elektronenstrahl in der Ebene des Objektes (11) parallel verschieben. Im Scan-Mode wird das Doppelablenksystem von einem nicht dargestellten Rastergenerator dynamisch angesteuert.

Die Auswahl derjenigen Blendenöffnung, durch die der in die Objektebene (11) fokussierte Elektronenstrahl transmittiert ist, erfolgt hier durch die der dritten Kondensorlinse zugewandte Ablenkeinheit des magnetischen Doppelablenksystems. In der Hauptebene der zweiten Kondensorlinse (3) ist eine Strahlbegrenzungsblende (4) angeordnet, deren Öffnungsdurchmesser (4a) so gewählt ist, daß alle Öffnungen (7a-7c) der Mehrfachblende (7) gleichzeitig ausgeleuchtet sind. Dies ist in der Figur 1 durch den gestrichelt dargestellten Strahlverlauf oberhalb der Mehrfachblende (7) angedeutet. Die Aperturwahl erfolgt im wesentlichen mit Hilfe des oberen Ablenkelements (8) des Doppelablenksystems (8, 9) zusammen mit einer in der Brennebene des Objektivs (10) angeordneten Objektivvorfeldblende (10a), deren Öffnungsdurchmesser so gewählt ist, daß stets nur das durch eine Öffnung (7a-7c) der Mehrfachblende (7) transmittierte Elektronenstrahlbündel die Objektivvorfeldblende (10a) transmittiert. Die durch die anderen Öffnungen der Mehrfachblende (7) transmittierten Strahlenbündel werden auf undurchlässige Bereiche der Objektivvorfeldblende (10a) gelenkt. Für die Aperturwahl und für das Scannen ist zwischen der dritten Kondensorstufe (6) und dem Objektiv (10) lediglich ein einziges Doppelablenksystem (8, 9) erforderlich, das beide Aufgaben gleichzeitig erfüllt. Da beim Scannen die Kippung in der Ebene der Objektivvorfeldblende (10a) erfolgt, entsteht durch die Blende kein Strahlbeschnitt. Zum Scannen werden beide Ablenkeinheiten des Doppelablenksystems synchron betrieben.

Zwischen der zweiten Kondensorlinse (3) und der dritten Kondensorlinse (6) ist noch ein zusätzliches Ablenksystem (5) derart angeordnet, daß dessen Kippebene mit der Eingangsbildebene der dritten Kondensorlinse (6) zusammenfällt. Dieses zusätzliche Ablenksystem ermöglicht die Ausrichtung des zentralen Bereiches des Elektronenstrahls auf diejenige Blendenöffnung (7a, 7b, 7c), die zur Einstellung der Apertur gerade gewählt ist.

Dadurch können etwaige negative Einflüsse aufgrund eines winkelabhängigen Elektronenstroms vermieden werden.

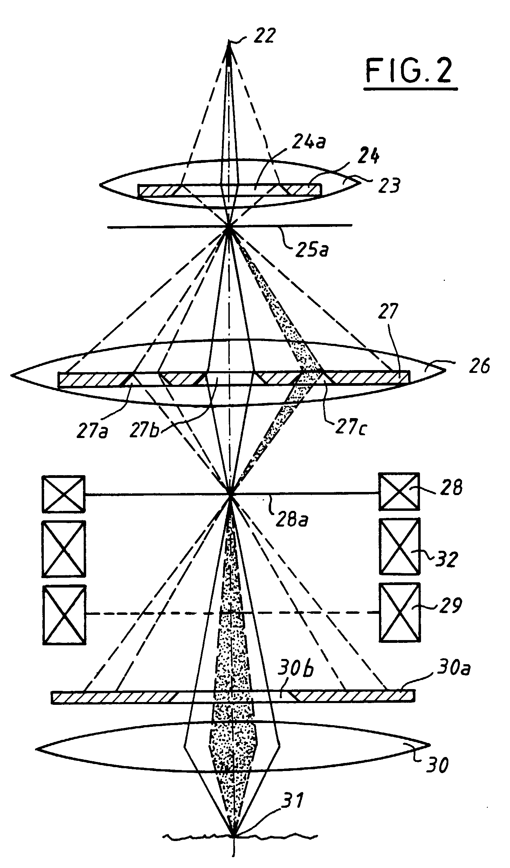

Zur näheren Beschreibung der Aperturblendenwahl sei auf die Figur 2 verwiesen. Aus Gründen der Übersichtlichkeit wurde hier auf eine nochmalige Darstellung des Crossovers und der ersten Kondensorlinse verzichtet. Vielmehr ist hier mit (22) das innerhalb des Zoomsystem entstehende Zwischenbild des Crossovers bezeichnet. Dieses Zwischenbild, das hier als reelles Zwischenbild dargestellt ist, kann je nach der Zoom-Einstellung reell oder virtuell sein. Die übrigen Komponenten, die denen in der Figur 1 entsprechen, sind hier jeweils mit um einen Wert 20 größeren Bezugszeichen bezeichnet.

Die zweite Kondensorlinse (23) erzeugt wiederum ein stets reelles Zwischenbild des Crossovers in der Eingangsbildebene (25a) der dritten Kondensorlinse (26). Die Öffnung (24a) der Strahlbegrenzungsblende (24) ist so gewählt, daß sämtliche Öffnungen (27a, 27b, 27c) der Mehrfachblende (27) in der Hauptebene der dritten Kondensorlinse (26) ausgeleuchtet sind. Die durch alle drei hier dargestellten Blendenöffnungen (27a, 27b, 27c) transmittierten Elektronenstrahlbündel sind durch die abbildenden Eigenschaften der dritten Kondensorlinse (26) auf einen gemeinsamen Bereich in der Ausgangsbildebene (28a) der dritten Kondensorlinse (26) fokussiert. Für die Auswahl der zentralen Blendenöffnung (27b) ist das Ablenkelement (28) ohne Offset erregt. Der strahlverlauf aller Teilstrahlenbündel ist daher geradlinig fortgesetzt. Die durch außeraxiale Blendenöffnungen (27a, 27c) transmittierten Elektronenstrahlbündel treffen dann auf den elektronen-undurchlässigen Bereich der Objektivvorfeldblende (30a). Sie tragen daher zur Ausleuchtung des Objektes nicht bei. Lediglich das durch die zentrale Blendenöffnung (27b) transmittierte Elektronenstrahlbündel fällt auf die Öffnung (30b) der Objektivvorblende (30a) und wird vom Objektiv (30) auf das Objekt (31) fokussiert. Da das zur Beleuchtung des Objektes dienende Teilstrahlenbündel sämtliche Linsen zentral durchläuft, tritt hier kein außeraxialer Beleuchtungsastigmatismus auf. Der zwischen dem Objektiv (30) und dessen Eingangsbildebene (28a) angeordnete Stigmator (32), der aus zwei zueinander um 45° verdrehte Quadrupole besteht, dient in diesem Falle zur Korrektur des axialen Astigmatismus.

Ist eine Änderung der Apertur gewünscht, so wird das erste Ablenkelement (28) des Doppelablenksystems (28, 29) mit einem Offset beaufschlagt, so daß ein durch eine außeraxiale Blendenöffnung (27c) transmittiertes Elektronenstrahlbündel in Richtung auf die optische Achse umgelenkt wird. In der Figur 2 ist dieses für das durch die Öffnung (27c) transmittierte Strahlenbündel dargestellt. Da diejenigen Elektronenstrahlbündel, die durch die anderen Öffnungen (27a, 27b) der Mehrfachblende transmittiert sind, um gleiche Winkelbeträge abgelenkt werden, treffen diese nun auf undurchlässige Bereiche der Objektivvorblende (30a). Da die Öffnung (27c) einen kleineren Durchmesser als die Öffnung (27b) hat, ergibt sich damit auf dem Objekt auch eine kleinere Apertur des fokussierten Elektronenstrahls. Da bei Auswahl der außeraxialen Blendenöffnungen (27a, 27c) die zugehörigen Elektronenstrahlbündel die dritte Kondensorlinse (26) zur optischen Achse geneigt durchstrahlen, dient in diesem Falle der Stigmator (32) auch zur Korrektur des außeraxialen Astigmatismus, damit auf dem Objekt (31) ein stigmatisches Bild des Crossovers entsteht. Außerdem wird dem Doppelablenksystem (28, 29) je nach Position der ausgewählten Blendenöffnung (27a-27c) ein Shift-Offset-Wert überlagert, so daß Abweichungen der Position des Elektronenstrahlfokus auf dem Objekt (31) aufgrund von Linsen- oder Ablenkaberrationen vermieden sind. Unabhängig von der gewählten Beleuchtungsapertur und des durch das Zoomsystem eingestellten Fokusdurchmessers auf dem Objekt (31) kann das Objekt durch entsprechende Erregung des Doppel-Ablenksystems (28, 29) mit dem Elektronenstrahlfokus abgerastert werden.

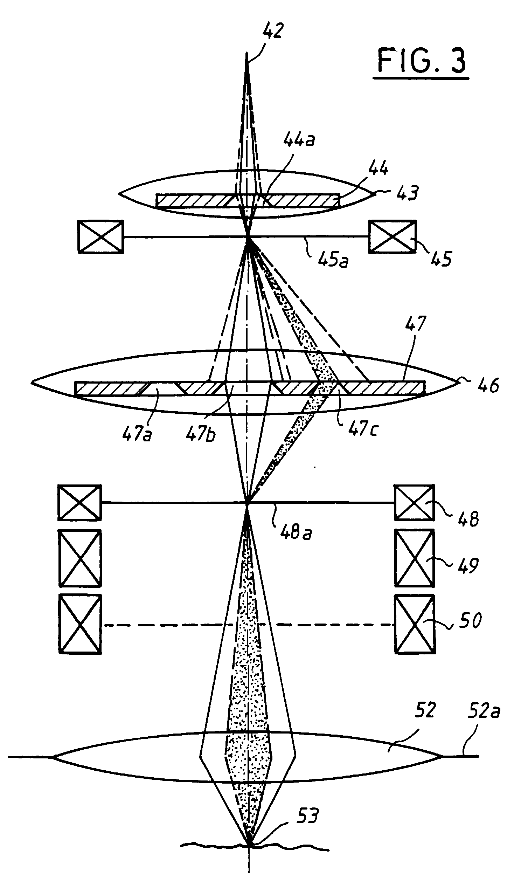

In der Figur 3 ist der untere Bereich eines zweiten Ausführungsbeispiels dargestellt, das ohne eine Objektivvorblende auskommt. Nicht dargestellt ist hier wiederum der Crossover und die erste Linse des Zoomsystems. Vielmehr ist mit (42) das innerhalb des Zoomsystems liegende reelle oder virtuelle Zwischenbild des Crossovers bezeichnet. Die zweite Kondensorlinse (43) bildet dieses Zwischenbild stets reell in die Eingangsbildebene (45a) der dritten Kondensorlinse (46) ab. Durch Variation der Brennweiten der ersten (nicht dargestellten) und zweiten Kondensorlinse (43) ist der Durchmesser des Crossover-Bildes in der Ebene (45a) variierbar. Wiederum erzeugt die dritte Kondensorlinse (46) ein zweites reelles Zwischenbild des Crossovers in der Eingangsbildebene (48a) der Objektivlinse (52), die letztendlich einen stark verkleinerten Elektronenstrahlfokus auf dem Objekt (53) erzeugt. Auch in diesem Ausführungsbeispiel ist in der Hauptebene der dritten Kondensorlinse (46) eine Mehrfachblende (47) angeordnet, die eine zentrale Öffnung (47b) und außeraxiale Öffnungen (47a, 47c) aufweist. Diese Blendenöffnungen (47a-47c) dienen wiederum als Aperturblenden.

Im Unterschied zu dem zuvor beschriebenen Ausführungsbeispiel weist die in der Hauptebene der zweiten Kondensorlinse (43) angeordnete Strahlbegrenzungsblende (44) nur eine kleine Öffnung (44a) auf. Der Durchmesser dieser Öffnung (44a) ist dabei so gewählt, daß jeweils nur eine einzige Öffnung der Mehrfachblende (47) ausgeleuchtet ist. Zur Auswahl der gewünschten Aperturblende ist hier ein Kondensorablenksystem (45) erforderlich. Dieses Kondensorablenksystem bewirkt bei Erregung eine Ablenkung des Elektronenstrahls, wobei die Kippebene mit der Eingangsbildebene der dritten Kondensorstufe (46) zusammenfällt.Da diese Ablenkung um die Eingangsbildebene der dritten Kondensorlinse (46) erfolgt, hat diese Ablenkung keinen Einfluß auf die Lage des Crossover-Bildes in der zweiten Zwischenbildebene (48a). Die Rücklenkung der Elektronenstrahlen, die durch außeraxiale Öffnungen der Mehrfachblende (47) transmittiert sind, erfolgt wiederum durch das erste Element eines magnetischen Doppelablenksystems (48, 50), das auch hier gleichzeitig zum Scannen des Elektronenstrahlfokus dient. Die Anordnung des Doppelablenksystem (48, 50) ist so, daß die Eingangsbildebene (48a) des Objektivs in der Kippebene des ersten Ablenkelementes (48) liegt und die gemeinsame Kippebene des gesamten Doppelablenksystems (48, 50) in der Hauptebene (52a) des Objektivs (52) liegt. Dadurch ist bei festen Kippebenen eine Variation des Arbeitsabstandes und die dafür erforderliche Brennweitenänderung des Objektivs (52) möglich. Der bei Verwendung außeraxialer Blendenöffnungen (47a, 47c) aufgrund des zur optischen Achse geneigten Strahlverlaufs innerhalb der dritten Kondensorlinse (46) erzeugte, außeraxiale Astigmatismus wird wiederum durch einen der Objektivlinse (52) vorgeschalteten Stigmator (49) korrigiert.

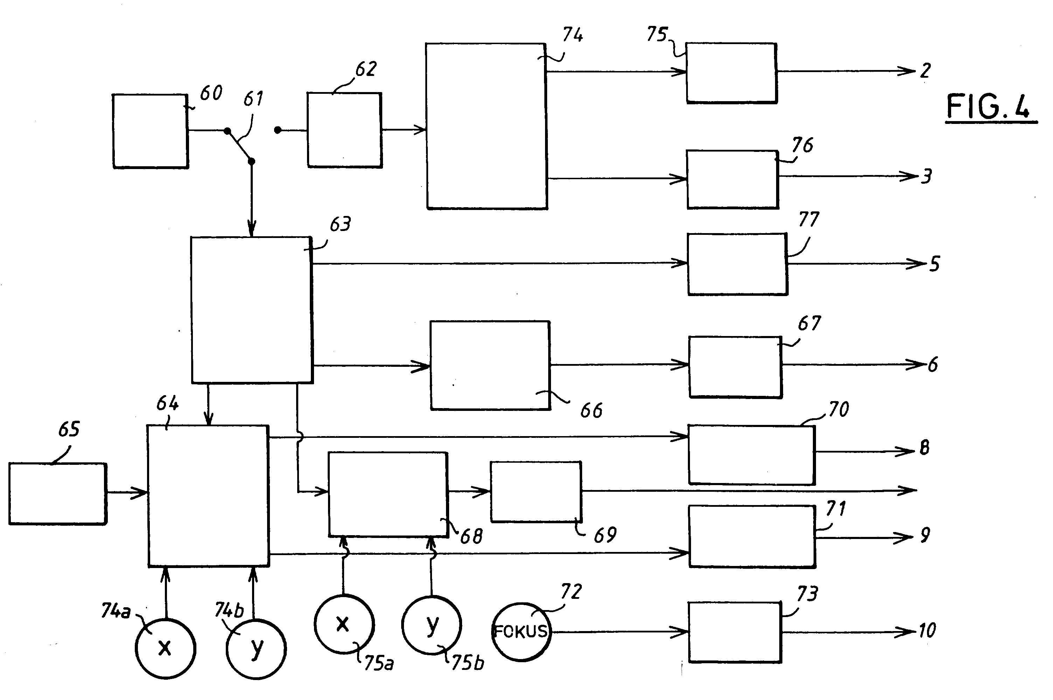

Die Figur 4 zeigt ein Blockdiagramm zur Ansteuerung der elektronen-optischen Komponenten bezüglich der Aperturauswahl. Der gewünschte Durchmesser des Elektronenstrahlfokus in der Objektebene ist über ein Tastenfeld (62) eingebbar. Dieses Tastenfeld steht mit einer Kontrolleinheit (74) für das Zoomsystem in Verbindung, die selbst wieder die Stromversorgung (75) für die erste Kondensorlinse (2) und eine zweite Stromversorgungseinheit (76) für die zweite Kondensorlinse (3) ansteuert. Desweiteren ist ein zweites Tastenfeld (60) zur manuellen Eingabe der gewünschten Sondenapertur, also der Bestrahlungs- oder Beleuchtungsapertur, vorgesehen. Über einen Umschalter (61) ist darüberhinaus anwählbar, ob die Apertur automatisch entsprechend des gewählten Fokusdurchmessers optimal angepaßt oder auf den mit der Tasteneinheit (60) eingegebenen Wert eingestellt sein soll. Eine Apertursteuereinheit (63) erzeugt ein erstes Ausgangssignal, das die Stromversorgung (77) für das Kondensorablenksystem (5) ansteuert. Ein zweites Ausgangssignal der Apertursteuereinheit (63) ist einer Kontrolleinheit (66) zur Ansteuerung der Stromversorgung (67) der dritten Kondensorlinse (6) zugeführt. Die Kontrolleinheit (66) bewirkt, daß die Stromversorgungseinheit (67) den Strom der dritten Kondensorstufe (6) stets nach einer definierten Prozedur, hier jeweils von der Hochstromseite, dem Arbeitsstrom annähert. Dadurch sind Fokusfehler aufgrund der Remanenz der Magnetlinse (6) vermieden.

Die Aperturkontrolleinheit (63) erzeugt zwei weitere Ausgangssignale, eines für die Doppelablenk-Kontrolleinheit (64) und ein weiteres für die Stigmator-Kontrolleinheit (68). Zur Aktivierung des Scanbetriebes ist ein Schalter an einer Steuereinheit (65) vorgesehen. Die Doppelablenk-Kontrolleinheit (64) verknüpft die statischen Werte für Strahlverschiebung und Strahlneigung, die mittels digitaler Encoder (74a, 74b) eingebbar sind, mit den Offsetwerten für die gewählte Beleuchtungsapertur und steuert die separaten Stromversorgungen (70, 71) für die beiden Ablenkeinheiten (8, 9) des Doppelablenksystems. Im Rasterbetrieb werden zusätzlich noch zwei sägezahnförmige Ablenkströme überlagert. Die Stigmator-Kontrolleinheit (68) steuert in Abhängigkeit von der vorgewählten Apertur die Stigmator-Stromversorgung (69) für die Stigmatoren (32, 49) zur Korrektur des axialen oder außeraxialen Astigmatismus an. Über zwei Stigmator-Drehgeber (75a, 75b) können diesen aperturangepaßten Stigmatorwerten zusätzlich manuell eingegebene Stigmatorwerte überlagert werden. Die Stigmator-Drehgeber können in einem anderen Betriebsmodus auch zur manuellen Eingabe von aperturangepaßten Stigmatorwerten verwendet werden.

## Patentansprüche

1. Verfahren zur Beleuchtung eines Objektes mit einem fokussierten Elektronenstrahl, bei dem der Crossover (1) einer Elektronenquelle über mindestens vier Abbildungsstufen (2, 3, 6, 10) verkleinert auf das Objekt abgebildet wird, wobei von den mindestens vier Abbildungsstufen (2, 3, 6, 10) mindestens zwei Abbildungsstufen (2, 3) durch Wahl der entsprechenden Linsenerregungen zur vorgebbaren Änderung der Verkleinerung des Crossovers dienen und bei dem der Elektronenstrahl durch eine in der Nähe einer Hauptebene einer weiteren Abbildungsstufe (6) angeordnete unter anderem mehrere außeraxiale Öffnungen (7a, 7b) aufweisende Mehrfachblende (7) zur Einstellung der Beleuchtungsapertur beschnitten wird.

2. Verfahren nach Anspruch 1, dadurch gekennzeichnet, daß der durch eine einzige außeraxiale Öffnung (7a, 7c) der Mehrfachblende (7) transmittierte Elektronenstrahl durch ein erstes Umlenkelement (8), dessen Kippebene in einer Zwischenbildebene (8a) des Crossovers liegt, in Richtung der gemeinsamen optischen Achse (1a) der Abbildungsstufen (2, 3, 6, 10) zurückgelenkt wird.

3. Verfahren nach Anspruch 2, dadurch gekennzeichnet, daß das erste Umlenkelement (8) Teil eines Doppelablenksystems (8, 9) ist und daß durch gemeinsame Anregung beider Elemente (8, 9) des Doppelablenksystems das Objekt (11) abgerastert wird.

4. Verfahren nach Anspruch 2, dadurch gekennzeichnet, daß der in Richtung der optischen Achse (1a) zurückgelenkte Elektronenstrahl nachfolgend einen Stigmator (32; 49) durchläuft, dessen Erregung entsprechend der durch den Umlenker (28; 48) bewirkten Rücklenkung gewählt ist.

5. Elektronen-optisches Beleuchtungssystem mit einer Strahlungsquelle, einem mindestens dreistufigen Kondensor (2, 3, 6) und einem dem Kondensor (2, 3, 6) nachgeschalteten Objektiv (10) zur verkleinerten Abbildung des Crossovers (1) der Strahlungsquelle in die Ausgangsbildebene (11) des Objektivs, wobei durch zwei erste Kondensorstufen (2, 3) ein erstes Zwischenbild des Crossovers (1) mit variablem Abbildungsmaßstab in der Eingangsbildebene (5a) der dritten Kondensorstufe (6) erzeugt ist und dieses erste Zwischenbild des Crossovers (1) durch die dritte Kondensorstufe (6) in die Eingangsbildebene (8a) des Objektivs (10) abgebildet ist, und mit einer dem Objektiv (10) vorgeschalteten Aperturblende, dadurch gekennzeichnet, daß die Aperturblende eine Mehrfachblende (7) mit mehreren Öffnungen (7a, 7b, 7c) unterschiedlicher Größe zur Einstellung einer bestimmten Beleuchtungsapertur ist und daß die Mehrfachblende zwischen der dritten Kondensorstufe (6) und der Eingangsbildebene (8a) des Objektivs (10), vorzugsweise in der Hauptebene der dritten Kondensorstufe (6) angeordnet ist.

6. Elektronen-optisches Beleuchtungssystem nach Anspruch 5, dadurch gekennzeichnet, daß ein erstes Ablenkelement (8) vorgesehen ist, dessen Kippebene in der Eingangsbildebene (8a) des Objektivs (10) liegt.

7. Elektronen-optisches Beleuchtungssystem nach Anspruch 6, dadurch gekennzeichnet, daß das erste Ablenkelement (8) Teil eines Doppelablenksystems (8, 9) ist, dessen gemeinsame Kippebene in der Hauptebene oder der Brennebene des Objektivs (10) liegt.

8. Elektronen-optisches Beleuchtungssystem nach einem der Ansprüche 5-7, dadurch gekennzeichnet, daß zwischen dem Objektiv (30; 52) und seiner Eingangsbildebene (28a; 48a) ein Stigmator (32; 49) vorgesehen ist.

9. Elektronen-optisches Beleuchtungssystem nach einem der Ansprüche 5-8, dadurch gekennzeichnet, daß vor der Eingansbildebene (5a) der dritten Kondensorstufe (6) eine Strahlbegrenzungsblende (4) vorgesehen ist.

10. Elektronen-optisches Beleuchtungssystem nach einem der Ansprüche 5-9, dadurch gekennzeichnet, daß die Mehrfachblende (27) großflächig ausgeleuchtet ist und daß in der Hauptebene oder der Brennebene des Objektivs (32) eine Objektivvorfeldblende (30a) zur Auswahl des durch eine einzige Öffnung (27a, 27b, 27c) der Mehrfachblende (27) transmittierten Elektronenstrahls vorgesehen ist.

11. Elektronen-optisches Beleuchtungssystem nach Anspruch 9, dadurch gekennzeichnet, daß der Öffnungsdurchmesser der Strahlbegrenzungsblende (49) derart gewählt ist, daß stets nur eine einzige Öffnung (47a, 47b, 47c) der Mehrfachblende ausgeleuchtet ist und daß ein Kondensorablenkelement (45) vorgesehen ist, dessen Kippebene in der Eingangsbildebene (45a) der dritten Kondensorstufe (46) liegt.

12. Elektronen-optisches Beleuchtungssystem nach Anspruch 8, dadurch gekennzeichnet, daß eine elektronische Stigmator-Steuereinheit (68) vorgesehen ist und daß der Stigmator-Strom in Abhängigkeit der vom ersten Ablenkelement (28; 48) bewirkten Strahlablenkung gewählt ist.

13. Elektronen-optisches Beleuchtungssystem nach einem der Ansprüche 5-12, dadurch gekennzeichnet, daß die Öffnungsdurchmesser der Mehrfachblende (7) alle kleiner als 100 µm sind.

14. Elektronen-optisches Beleuchtungssystem nach Anspruch 13, dadurch gekennzeichnet, daß der Abstufungsfaktor der Öffnungsdurchmesser kleiner als zwei ist.

15. Elektronen-optisches Beleuchtungssystem nach einem der Ansprüche 5-14, dadurch gekennzeichnet, daß Schaltmittel (61) zur wahlweisen manuellen oder automatischen Auswahl einer Öffnung (7a, 7b, 7c) der Mehrfachblende (7) vorgesehen sind, wobei bei automatischer Auswahl die Apertur an den Durchmesser des Crossover-Bildes angepaßt ist.

## Claims

1. Method for illuminating an object with a focused electron beam with which the crossover (1) of an electron source is imaged onto the object demagnified via at least four imaging lens stages (2, 3, 6, 10), whereby at least two imaging lens stages (2, 3) of said at least four imaging lens stages (2, 3, 6, 10) serve for an adjustment of the demagnification of the crossover in a pre-given manner by selection of the respective lense exitations and with which the electron beam is cropped for an adjustment of the illuminating aperture by a multiple diaphragm (7) having, besides others, several off-axis apertures (7a, 7b) and being arranged in the vicinity of a main plane of a further imaging lens stage (6).

2. Method of claim 1, characterized in that the electron beam transmitted through a single off-axis aperture (7a, 7c) of the multiple diaphragm (7) is deflected back into the direction of the common optical axis (1a) of the imaging lens stages (2, 3, 6, 10) by a first deflecting element (8) having a tilt plane in the plane of the intermediate image plane (8a) of the crossover.

3. Method of claim 2, characterized in that the deflecting element (8) is a component of a double deflecting system (8, 9) and that the object (11) is scanned by common excitation of both components (8, 9) of the double deflecting system.

4. Method of claim 2, characterized in that the electron beam deflected back in the direction of the optical axis afterwards passes a stigmator (32, 49) the excitation of which is adjusted according to the back deflection caused by the deflecting element (28; 48).

5. Electron optical illuminating system with a radiation source, a condensor having at least three stages (2, 3, 6) and an objective (10) arranged behind the condensor(2, 3, 6) for a demagnified imaging of the crossover (1) of the radiation source into the exit image plane (11) of the objective, whereby by two first stages (2, 3) of said condensor a first intermediate image of the crossover (1) is generated with a variable imaging scale within the entrance image plane (5a) of the third stage (6) of the condensor and this first intermediate image of the crossover (1) is imaged by the third stage (6) of the condensor into the entrance image plane (8a) of the objective (10), and with an aperture diaphragm arranged upstream of the objective (10), characterized in that the aperture diaphragm is a multiple diaphragm (7) with at least several openings (7a, 7b, 7c) of different size for adjustment of a defined illuminating aperture and that the multiple diaphragm is positioned between the third stage (6) of the condensor and the entrance image plane (8a) of the objective (10), preferably in the main plane of the third stage (6) of the condensor.

6. Electron optical illuminating system of claim 5, characterized in that a first deflecting element having the tilt plane in the entrance image plane (8a) of the objective (10) is provided.

7. Electron optical illuminating system of claim 6, characterized in that the deflecting element (8) is a portion of a double deflecting system (8, 9) having a common tilt plane coinciding with the main plane or with the focal plane of the objective (10).

8. Electron optical illuminating system of one of the claims 5 to 7, characterized in that a stigmator (32, 49) is provided between the objective (30; 52) and the entrance image plane (28a;48a).

9. Electron optical illuminating system of one of the claims 5 to 8, characterized in that a beam limiting aperture (4) is provided between the entrance image plane (5a) and the third stage (6) of the condensor.

10. Electron optical illuminating system of one of the claims 5 to 9, characterized in that a large area of the multiple diaphragm (27) is illuminated and that an objective prefield diaphragm (30a) for selecting the electron beam transmitted through a singly opening (27a, 27b, 27c) of the multiple diaphragm (27) is arranged within the main plane or the focal plane of the objective (32).

11. Electron optical illuminating system of claim 9, characterized in that the opening diameter of the beam limiting aperture (49) is selected so as to cause only a single opening (47a, 47b, 47c) of the multiple diaphragm to be illuminated and that a condensor deflecting element (45) having a tilt plane in the entrance image plane (45a) of the third stage (46) of the condensor is provided.

12. Electron optical illuminating system of claim 8, characterized in that an electronic stigmator control unit (68) is provided and that the stigmator current is selected in dependence on the deflection caused by the first deflecting element (28; 48).

13. Electron optical illuminating system of one of the claims 5 to 12, characterized in that the opening diameters of the multiple diaphragm (7) each having a diameter less than 100µm.

14. Electron optical illuminating system of claim 13, characterized in that the stepping-down ratio of the opening diameters is less than two.

15. Electron optical illuminating system of one of the claims 5 to 14, characterized in that switching means (61) for selecting between a manual or automatical selection of one opening (7a, 7b, 7c) of the multiple diaphragm (7) are provided, whereby in the case of an automatic selection the aperture is adapted to the diameter of the crossover image.

## Revendications

1. Procédé d'éclairage d'un objet à l'aide d'un faisceau électronique, selon lequel le point de croisement (1) d'une source d'électrons est projeté sous la forme d'une image réduite sur l'objet par quatre optiques de reproduction (2, 3, 6, 10) au minimum dont deux au moins (2,3) servent à modifier au préalable le rapetissement du point de croisement, en excitant les lentilles par un flux sélectif approprié, et selon lequel le faisceau électronique est circonscrit pour régler l'angle du champ lumineux au moyen d'un diaphragme multiple (7) qui présente notamment plusieurs ouvertures extra-axiales (7a, 7c) et qui est disposé à proximité du plan principal de l'une des autres optiques de reproduction (6).

2. Procédé selon la revendication 1, caractérisé en ce que le faisceau électronique transmis à travers une seule ouverture extra-axiale (7a, 7c) du diaphragme multiple (7) est renvoyé en direction de l'axe commun (1) des optiques de reproduction (2, 3, 6, 10) par un premier élément de déviation (8) dont le plan d'oscillation se trouve dans le plan de l'image intermédiaire (8a) du point de croisement.

3. Procédé selon la revendication 2, caractérisé en ce que le premier élément de déviation (8) fait partie d'un double système de déflexion (8, 9) et en ce que l'objet (11) est balayé par l'excitation conjointe des deux éléments (8, 9) du double système de déflexion.

4. Procédé selon la revendication 2, caractérisé en ce que le faisceau électronique renvoyé en direction de l'axe optique (1a) traverse ensuite un stigmateur (32; 49) dont l'excitation est modulée en fonction de la retrodiffusion induite par le réflecteur (28; 48).

5. Système d'éclairage opto-électronique composé d'une source de rayonnement, d'un condenseur à trois optiques au minimum (2, 3, 6) et d'un objectif (10) placé après ledit condenseur (2, 3, 6) en vue de réduire l'image reproduite du point de croisement (1) de la source de rayonnement dans le plan de reproduction (11) à la sortie de l'objectif, dans lequel une première image intermédiaire du point de croisement (1) est générée selon une échelle variable dans le plan de reproduction d'entrée (5a) de la troisième optique du condenseur (6) au moyen des deux premières optiques du condenseur (2, 3) et dans lequel cette première image intermédiaire du point de croisement (1) est projetée dans le plan d'image d'entrée (8a) de l'objectif (10) par la troisième optique du condenseur (6), et composé par ailleurs d'un diaphragme d'ouverture disposé devant l'objectif (10), caractérisé en ce que ce diaphragme d'ouverture de type multiple (7) présente plusieurs ouvertures (7a, 7b, 7c) de tailles différentes destinées à régler l'angle du champ lumineux et en ce que ledit diaphragme multiple est intercalé entre la troisième optique du condenseur (6) et le plan d'image d'entrée (8a) de l'objectif (10), de préférence dans le plan principal de la troisième optique du condenseur (6).

6. Système d'éclairage opto-électronique selon la revendication 5, caractérisé en ce qu'un premier élément de déviation (8) est prévu dont le plan d'oscillation se trouve dans le plan d'image d'entrée (8a) de l'objectif.

7. Système d'éclairage opto-électronique selon la revendication 6, caractérisé en ce que le premier élément de déviation (8) fait partie d'un double système de déflexion (8, 9) dont le plan d'oscillation commun est situé dans le plan principal ou dans le plan focal de l'objectif (10).

8. Système d'éclairage opto-électronique selon l'une des revendications 5-7, caractérisé en ce qu'un stigmateur (32; 49) est interposé entre l'objectif (30; 52) et son plan d'image d'entrée (28a; 48a).

9. Système d'éclairage opto-électronique selon l'une des revendications 5-8, caractérisé en ce qu'un diaphragme de limitation du faisceau (4) est installé devant le plan d'image d'entrée (5a) de la troisième optique du condenseur (6).

10. Système d'éclairage opto-électronique selon l'une des revendications 5-9, caractérisé en ce que le diaphragme multiple (27) est éclairé sur une grande surface et qu'un diaphragme de champ en amont de l'objectif (30a) est prévu dans le plan principal ou le plan focal de l'objectif (30) pour sélectionner le faisceau électronique transmis à travers une seule des ouvertures (27a, 27b, 27c) du diaphragme multiple (27).

11. Système d'éclairage opto-électronique selon la revendication 9, caractérisé en ce que le diamètre d'ouverture du diaphragme de limitation du faisceau (49) est choisi de façon à ce que toujours une seule des ouvertures (47a, 47b, 47c) du diaphragme multiple soit éclairée et en ce qu'un élément de déviation du condenseur (45) est prévu dont le plan d'oscillation se trouve dans le plan d'image d'entrée (45a) de la troisième optique du condenseur (46).

12. Système d'éclairage opto-électronique selon la revendication 8, caractérisé en ce qu'une unité de commande électronique du stigmateur (68) est installée et que le courant appliqué au stigmateur est déterminé en fonction de la déflexion du faisceau induite par le premier élément de déviation (28; 48).

13. Système d'éclairage opto-électronique selon l'une des revendications 5-12, caractérisé en ce que les diamètres d'ouverture du diaphragme multiple (7) sont tous inférieurs à 100 µm.

14. Système d'éclairage opto-électronique selon la revendication 13, caractérisé en ce que le facteur de variation des diamètres d'ouverture est inférieur à deux.

15. Système d'éclairage opto-électronique selon l'une des revendications 5-14, caractérisé en ce que des commutateurs (61) sont prévus pour sélectionner manuellement ou automatiquement une ouverture (7a, 7b, 7c) du diaphragme multiple (7), l'ouverture étant adaptée au diamètre de l'image du point de croisement en mode automatique.
